# EUROPEAN PATENT APPLICATION

(11) **EP 4 576 964 A1**
(43) Date of publication of application: **25.06.2025**
(21) Application number: 23869949.0
(22) Date of filing: 25.07.2023
(51) Int. Cl.: H05K 7/20

(54) **HEAT DISSIPATION SYSTEM AND POWER APPARATUS**

(30) Priority: 28.09.2022 CN 202211193985
(71) Applicant: Huawei Digital Power Technologies Co., Ltd., Shenzhen, Guangdong 518043 (CN)
(72) Inventor: LI, Jiyang, Shenzhen, Guangdong 518043 (CN); FAN, Guohua, Shenzhen, Guangdong 518043 (CN); LIU, Zhiling, Shenzhen, Guangdong 518043 (CN); LI, Quanming, Shenzhen, Guangdong 518043 (CN)
(74) Representative: Goddar, Heinz J.
(86) International application number: PCT/CN2023/109112
(87) International publication number: WO 2024/066703

(57) **Abstract**

This application provides a heat dissipation system and a power device. The heat dissipation system may include a power module, an evaporator, and a condenser. The power module includes a thermally conductive substrate and a power component, and the power component is fastened to a first surface of the thermally conductive substrate. The evaporator has an evaporation chamber, and the evaporation chamber is filled with a refrigerant. At least one sidewall of the evaporator is provided with a window, the thermally conductive substrate is embedded into the window, at least a part of surfaces of the thermally conductive substrate is immersed in the refrigerant, and the first surface is located on an outer side of the evaporation chamber. Heat generated by the power component is conducted by the thermally conductive substrate to the refrigerant to vaporize the refrigerant. The condenser communicates with the evaporation chamber, and the vaporized refrigerant may enter the condenser. The refrigerant condensed into a liquid state by the condenser may flow back to the evaporation chamber. The heat generated by the power component can be taken away through phase-change heat exchange of the refrigerant, and thermal resistance from the power module to air can be reduced. This can improve a heat dissipation capability of the power module, thereby helping improve product performance of a power device in which the heat dissipation system is used.

## Description

### CROSS-REFERENCE TO RELATED APPLICATIONS

This application claims priority to Chinese Patent Application No. 202211193985.5, filed with the China National Intellectual Property Administration on September 28, 2022 and entitled "HEAT DISSIPATION SYSTEM AND ELECTRONIC DEVICE", which is incorporated herein by reference in its entirety.

### TECHNICAL FIELD

This application relates to the field of heat dissipation technologies, and in particular, to a heat dissipation system and a power device.

### BACKGROUND

With development of electronic technologies, high-power semiconductor devices are increasingly widely used in the power electronics industry. Because a computing capability of the high-power semiconductor device is continuously improved, power consumption of the high-power semiconductor device also increases greatly. Consequently, the high-power semiconductor device generates more heat, and heat flow density is increasing. This poses a huge challenge to heat dissipation of the high-power semiconductor device.

Currently, a power device develops towards miniaturization and integration, and leaves little space for disposing a heat dissipation assembly. However, if there is no good heat dissipation measure for the high-power semiconductor device, a use environment of the high-power semiconductor device is limited, and product performance is also limited. Therefore, a heat dissipation capability of the high-power semiconductor device at high power density needs to be improved urgently.

### SUMMARY

This application provides a heat dissipation system and a power device, to improve a heat dissipation capability of a power module, thereby improving product performance of a power device in which the heat dissipation system is used.

According to a first aspect, this application provides a heat dissipation system. The heat dissipation system includes a power module, an evaporator, and a condenser. The power module may include a thermally conductive substrate and a power component, the thermally conductive substrate has a first surface, the power component may be fastened to the first surface, and the power component may be in thermally conductive contact with the first surface. It should be noted that one or more power components may be disposed on each thermally conductive substrate. This is not limited in this application. In addition, the evaporator has an evaporation chamber, and the evaporation chamber is filled with a refrigerant. The power module is disposed in the evaporator. Specifically, at least one sidewall of the evaporator may be provided with a window, the thermally conductive substrate is embedded into the evaporator via the window, and at least a part of surfaces of the thermally conductive substrate is immersed in the refrigerant. In this case, heat generated by the power component may be conducted from the first surface to the thermally conductive substrate, and is further conducted from the thermally conductive substrate to the refrigerant, and the refrigerant may be heated and vaporized into vapor. The condenser communicates with the evaporation chamber, and the vaporized refrigerant may enter the condenser.

According to the heat dissipation system provided in this application, when the power module works, the heat may be conducted from the power component to the first surface of the thermally conductive substrate, and may be further conducted to the liquid refrigerant in the evaporation chamber of the evaporator. The liquid refrigerant is heated and vaporized to form the vapor. The vapor enters the condenser, and flows back to the evaporation chamber after the vapor is condensed into a liquid state. It can be understood that, in the foregoing refrigerant phase-change process, a large amount of heat generated by the power component may be taken away, to perform heat dissipation for the power component. In addition, phase-change heat exchange of the refrigerant can be used to effectively reduce thermal resistance from the power module to air, thereby effectively improving a heat dissipation capability of the power module.

In a possible implementation of this application, the refrigerant may flow back to the evaporation chamber under an action of gravity after the refrigerant is condensed into the liquid state by the condenser. In this way, without being driven by a pump or another power device, the refrigerant condensed into the liquid refrigerant through the condenser may flow back to the evaporation chamber under the action of gravity, thereby implementing efficient cycling of the refrigerant between the evaporator and the condenser.

In this application, a placement manner of the heat dissipation system is not limited, and the heat dissipation system may be placed based on a specific application scenario. For example, the heat dissipation system may be placed in a gravity direction. The gravity direction may be defined as a direction from the top to the bottom when a device in which the heat dissipation system is used is in a normal use state and is placed in a customary manner in the art. For example, when the heat dissipation system is used in a photovoltaic inverter, and the photovoltaic inverter is in the normal use state, the gravity direction may be understood as a direction from the top to the bottom of the photovoltaic inverter. In this case, the heat dissipation system is placed in the direction from the top to the bottom of the photovoltaic inverter.

In addition, when the heat dissipation system is placed in the gravity direction, the condenser may be located above the evaporator. Based on this, when the thermally conductive substrate is placed, in a possible implementation, a thickness direction of the thermally conductive substrate may be perpendicular to the gravity direction. In this case, it can be understood that the thermally conductive substrate is embedded into a window provided on a sidewall that is of the evaporator and that is parallel to the gravity direction.

Because the first surface of the thermally conductive substrate may be configured to dispose the power component, in a possible implementation of this application, the thickness direction of the thermally conductive substrate may be further perpendicular to the first surface. In this case, the first surface is parallel to the gravity direction.

When the evaporator is specifically connected to the condenser, the evaporator may be connected to the condenser through a pipeline. In a possible implementation of this application, the evaporator may be connected to the condenser through at least one liquid flowing pipeline and at least one gas flowing pipeline. For example, the evaporator may be connected to the condenser through one liquid flowing pipeline and one gas flowing pipeline, or the evaporator may be connected to the condenser through one liquid flowing pipeline and two gas flowing pipelines, so that a gas flowing path and a liquid flowing path in which the refrigerant cycles between the evaporator and the condenser can be distinguished, to improve efficiency of the refrigerant cycling between the evaporator and the condenser.

In this application, the thermally conductive substrate further has a second surface, the second surface and the first surface are disposed away from each other, and at least a part of the second surface is immersed in the refrigerant. After the heat generated by the power component is conducted from the first surface of the thermally conductive substrate to the second surface, the heat may be directly transferred to the refrigerant, to implement efficient heat exchange between the thermally conductive substrate and the refrigerant.

In a possible implementation of this application, the at least a part of surfaces that is of the thermally conductive substrate and that is immersed in the refrigerant may include the second surface and at least a part of an outer side surface of the thermally conductive substrate. The outer side surface of the thermally conductive substrate may be located between the first surface and the second surface. In this way, a contact area between the thermally conductive substrate and the refrigerant can be large, thereby helping improve efficiency of heat exchange between the thermally conductive substrate and the refrigerant.

To improve heat dissipation efficiency of the power module, in a possible implementation of this application, a heat dissipation enhancement structure may be further disposed on the thermally conductive substrate. During specific implementation, the heat dissipation enhancement structure is disposed in a heat dissipation enhancement region of the second surface, and the heat dissipation enhancement structure may be configured to increase an area of the thermally conductive substrate immersed in the refrigerant. In this way, in the thickness direction of the thermally conductive substrate, at least a part of projection of the power module on the second surface may be located in the heat dissipation enhancement region, so that heat exchange can be efficiently performed between the heat generated by the power module and the refrigerant, to help improve heat dissipation performance of the power module.

In this application, a specific disposing form of the heat dissipation enhancement structure is not limited. For example, the heat dissipation enhancement structure may be a groove or a protrusion located on the second surface, or may be a fin or a capillary structure, so that the area of the thermally conductive substrate immersed in the refrigerant can be increased.

In a possible implementation of this application, projection of the power component on the thermally conductive substrate may fall within a contour range of the first surface, to effectively increase a contact area between the power component and the thermally conductive substrate, thereby helping improve efficiency of heat exchange between the power component and the thermally conductive substrate.

In a possible implementation of this application, the outer side surface of the thermally conductive substrate is connected to an inner sidewall of the window in a sealed manner, to avoid refrigerant leakage. In addition, to reliably connect the thermally conductive substrate to the evaporator, the thermally conductive substrate may be connected to the evaporator through welding, bonding, or the like.

In a possible implementation of this application, the inner sidewall of the window of the evaporator may be disposed in a step shape, and the inner sidewall of the window may include a first inner sub-sidewall, a second inner sub-sidewall, and a connection wall connecting the first inner sub-sidewall and the second inner sub-sidewall. An area of an opening circumferentially encircled by the first inner sub-sidewall is greater than an area of an opening circumferentially encircled by the second inner sub-sidewall. In addition, the thermally conductive substrate is located in the opening circumferentially encircled by the first inner sub-sidewall, and a part of the second surface is in overlapping contact with the connection wall. This can facilitate mounting of the thermally conductive substrate and the evaporator, and can improve tightness of fitting the thermally conductive substrate and the evaporator.

In addition, the second surface of the thermally conductive substrate may further include at least one protruding portion, and the protruding portion may extend into the evaporation chamber through the opening circumferentially encircled by the second inner sub-sidewall. In this way, the at least one protruding portion is immersed in the refrigerant in the evaporation chamber, so that the area of the thermally conductive substrate immersed in the refrigerant is large. This helps improve the efficiency of heat exchange between the thermally conductive substrate and the refrigerant.

In this application, to ensure airtightness between the thermally conductive substrate and the window, the outer side surface of the thermally conductive substrate may be connected to the first inner sub-sidewall in the sealed manner; or the part of the second surface that is of the thermally conductive substrate and that is in overlapping contact with the connection wall is connected to the connection wall in the sealed manner. During specific implementation, a sealing ring may be disposed between the outer side surface of the thermally conductive substrate and the inner sidewall of the window. The sealing ring may be sleeved on the thermally conductive substrate, and the inner sidewall of the window may press the sealing ring, so that the sealing ring fills a gap between the thermally conductive substrate and the window.

In addition, in this application, a specific arrangement manner of the thermally conductive substrate is not limited. For example, there may be a first included angle between the first surface of the thermally conductive substrate and the gravity direction, and the first included angle may be greater than or equal to 0° and less than or equal to 180°. The thermally conductive substrate may be adjusted based on arrangement space of the heat dissipation system and the like, so that the heat dissipation system is flexibly arranged.

In a possible implementation of this application, each evaporator may be connected to at least two power modules. This helps implement an integrated design of the heat dissipation system.

According to a second aspect, this application further provides a power device. The power device may include a chassis and the heat dissipation system according to the first aspect. The evaporator may be located inside or outside the chassis, and the condenser is located outside the chassis. In this application, a specific type of the power device is not limited, and the power device may be but is not limited to a photovoltaic power generation device like a photovoltaic inverter. The power device has a strong heat dissipation capability, so that product performance of the power device can be improved, thereby improving product competitiveness of the power device.

### BRIEF DESCRIPTION OF DRAWINGS

FIG. 1 is a diagram of a structure of a heat dissipation system according to an embodiment of this application;
FIG. 2 is a diagram of a structure of a power module according to an embodiment of this application;
FIG. 3a is a cross-sectional view of a position of connection between a power module and an evaporator according to an embodiment of this application;
FIG. 3b is a diagram of a mode of connection between a power module and an evaporator according to an embodiment of this application;
FIG. 4a to FIG. 4g are diagrams of structures of several second surfaces according to an embodiment of this application;
FIG. 5a is a diagram of a connection relationship of a heat dissipation system according to an embodiment of this application;
FIG. 5b is a diagram of a connection relationship of another heat dissipation system according to an embodiment of this application;
FIG. 5c is a diagram of a structure of a connection relationship of another heat dissipation system according to an embodiment of this application; and
FIG. 6 is a diagram of a structure of a power device according to an embodiment of this application.

### Reference numerals:

1: power module; 101: power component; 102: thermally conductive substrate; 1021: first surface; 1022: second surface;
   10221: protruding portion; 10222: heat dissipation enhancement region; 1023: outer side surface; 1024: fin; 1025: capillary structure;
2: evaporator; 201: evaporation chamber; 202: window; 2021: first inner sub-sidewall; 2022: second inner sub-sidewall;
   2023: connection wall; 3: condenser; 4: liquid flowing pipeline; 5: gas flowing pipeline; and 6: chassis.

### DESCRIPTION OF EMBODIMENTS

Terms used in the following embodiments are merely intended to describe particular embodiments, but are not intended to limit this application. The singular expression "one", "a/an", "said", "the foregoing", "the", and "this" as used in this specification and the appended claims of this application are also intended to include expressions such as "one or more", unless otherwise specified in the context clearly. Reference to "an embodiment", "a specific embodiment", or the like described in this specification means that one or more embodiments of this application include a specific feature, structure, or characteristic described with reference to the embodiment. The terms "include", "contain", "have", and their variants all mean "include but are not limited to", unless otherwise specifically emphasized.

To facilitate understanding of a heat dissipation system and a power device provided in embodiments of this application, the following first describes an application scenario of the heat dissipation system and the power device. The heat dissipation system provided in this application may be used in, but is not limited to, a power device like a photovoltaic inverter. With development of electronic technologies, more heat dissipation requirements are posed on high-power semiconductor devices in power devices. For example, in the photovoltaic inverter, heat flow density of an insulated gate bipolar transistor (IGBT) is increasingly high. A good heat dissipation measure helps improve a maximum current output capability of the insulated gate bipolar transistor, thereby improving performance of the photovoltaic inverter and improving product competitiveness.

For improvement of power density of the high-power semiconductor device, currently, heat dissipation enhancement research on the high-power semiconductor device is very extensive. Heat dissipation modes mainly include air cooling, natural cooling, and liquid cooling, and a specific heat dissipation mode is selected based on an actual application scenario. For example, the photovoltaic inverter is mainly used in an outdoor scenario, and the air cooling is a main heat dissipation form of the photovoltaic inverter. For air-cooled heat dissipation, the high-power semiconductor device is usually attached to a surface of an air-cooled heat sink via thermally conductive silicone grease for heat dissipation. Currently, heat dissipation enhancement research on the air-cooled heat dissipation is mainly a solution in which a heat pipe heat sink or a vapor chamber (VC) heat sink is added on a basis of a common aluminum air-cooled heat sink, and the like. However, a bottleneck is encountered in future evolution. In addition, based on distribution of thermal resistance of a heat dissipation link, thermal resistance of a thermally conductive silicone grease layer accounts for 20%. Currently, there is no good alternative solution for reducing the thermal resistance.

Based on this, this application provides a heat dissipation system and a power device, to remove the silicone grease layer from the heat dissipation link by directly contacting a heat dissipation surface of a power module with a refrigerant, and reduce thermal resistance from the module to air through efficient phase-change heat exchange, thereby improving a heat dissipation capability of the power module. This helps improve product performance of a power device in which the heat dissipation system is used, and improve product competitiveness. To make the objectives, technical solutions, and advantages of this application clearer, the following further describes this application in detail with reference to the accompanying drawings.

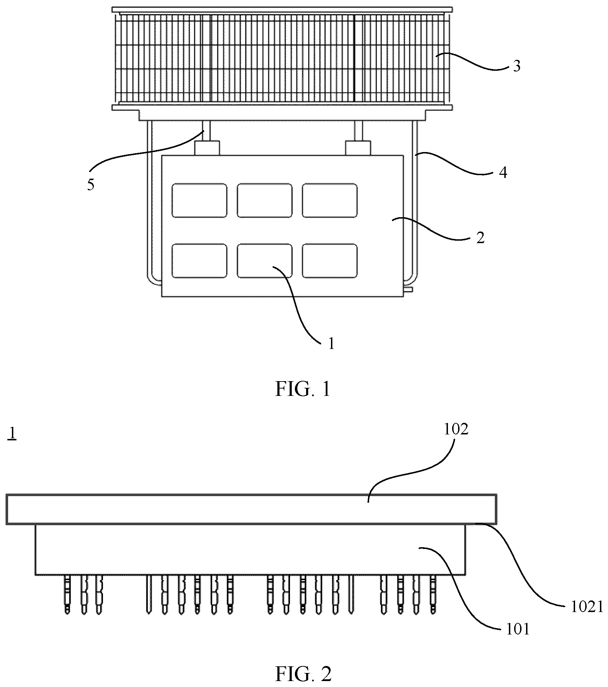

FIG. 1 is a diagram of a structure of a heat dissipation system according to an embodiment of this application. In this application, the heat dissipation system may include a power module 1, an evaporator 2, and a condenser 3. The power module 1 is fastened to the evaporator 2, and the evaporator 2 is connected to the condenser 3. In addition, a plurality of power modules 1 may be disposed on each evaporator 2. For example, in the heat dissipation system shown in FIG. 1, six power modules 1 are disposed on one evaporator 2, and the evaporator 2 is connected to one condenser 3. This facilitates an integrated design of the heat dissipation system.

When the power module 1 is specifically disposed, refer to FIG. 2. FIG. 2 is a diagram of a structure of the power module 1 according to an embodiment of this application. The power module 1 includes a power component 101 and a thermally conductive substrate 102. The power component 101 may be but is not limited to a chip, a database controller (DBC), or the like. The power component 101 may be disposed on a first surface 1021 of the thermally conductive substrate 102, and the power component 101 is in thermally conductive contact with the first surface 1021 of the thermally conductive substrate 102. In addition, one or more power components 101 may be disposed on each thermally conductive substrate 102, and a quantity of the power components may be disposed based on a specific application scenario of the power module 1.

In this application, a material of the thermally conductive substrate 102 is not limited. For example, the thermally conductive substrate 102 may be a metal with good thermal conductivity like copper or aluminum. In some possible embodiments, the material of the thermally conductive substrate 102 may alternatively be a non-metal with good thermal conductivity.

It can be understood that, in this application, projection of the power component 101 on the thermally conductive substrate 102 can completely fall within a contour range of the first surface 1021, so that a contact area between the power component 101 and the first surface 1021 can be effectively increased. This helps improve efficiency of heat exchange between the power component 101 and the thermally conductive substrate 102, and further improve heat dissipation performance of the power module 1.

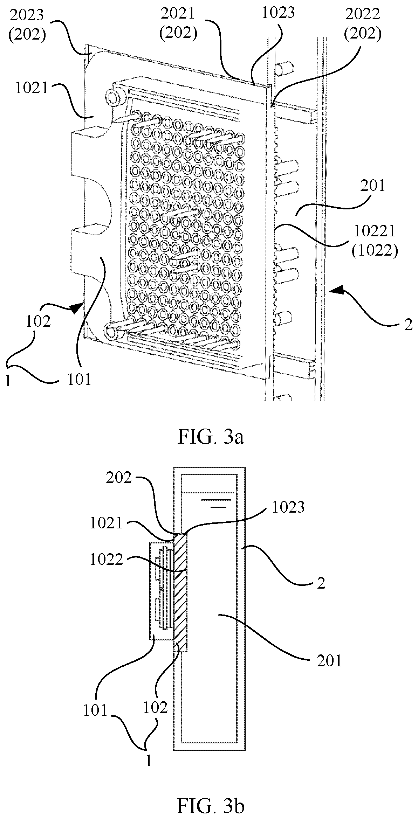

FIG. 3a is a cross-sectional view of a position of connection between the power module 1 and the evaporator 2 according to an embodiment of this application. In this application, the evaporator 2 has an evaporation chamber 201, the evaporation chamber 201 is filled with a refrigerant, and the refrigerant is a vapor-liquid two-phase refrigerant. In other words, when a temperature is less than or equal to a first temperature threshold, the refrigerant is in a liquid state. When the temperature is higher than the first temperature threshold, the refrigerant boils and changes to vapor through phase change. A specific type of the refrigerant is not limited in this application. For example, the refrigerant may be tetrafluoroethane (1,1,1,2-tetrafluoroethane) or the like. It can be understood that the first temperature threshold is affected by a type of the refrigerant, and may be, for example, 20°C or 25°C.

Still refer to FIG. 3a. To fasten the power module 1 to the evaporator 2, at least one sidewall of the evaporator 2 may be provided with a window 202, and the thermally conductive substrate 102 of the power module 1 may be embedded into the window 202, so that at least a part of surfaces of the thermally conductive substrate 102 is immersed in the refrigerant in the evaporation chamber 201.

In this application, the thermally conductive substrate 102 may further include a second surface 1022, and the second surface 1022 and the first surface 1021 are disposed away from each other. In this case, the at least a part of surfaces that is of the thermally conductive substrate 102 and that is immersed in the refrigerant may include at least a part of the second surface 1022. In this case, the at least a part of the second surface 1022 is immersed in the refrigerant.

In a possible embodiment of this application, refer to FIG. 3b. FIG. 3b is a diagram of a mode of connection between a power module and an evaporator according to an embodiment of this application. In FIG. 3b, the at least a part of surfaces that is of the thermally conductive substrate 102 and that is immersed in the refrigerant may include the entire second surface 1022 and at least a part of an outer side surface 1023 of the thermally conductive substrate 102. The outer side surface 1023 of the thermally conductive substrate 102 may be located between the first surface 1021 and the second surface 1022. In this way, a contact area between the thermally conductive substrate 102 and the refrigerant can be increased, thereby improving efficiency of heat exchange between the thermally conductive substrate 102 and the refrigerant.

In this application, the thermally conductive substrate 102 may be fastened to the evaporator 2, and a manner of fastening the thermally conductive substrate 102 and the evaporator 2 may be but is not limited to welding, bonding, or the like. Refer to FIG. 3a. To facilitate the connection between the thermally conductive substrate 102 and the evaporator 2, an inner sidewall of the window 202 may be disposed in a step shape. In this case, the inner sidewall of the window may include a first inner sub-sidewall 2021, a second inner sub-sidewall 2022, and a connection wall 2023 connecting the first inner sub-sidewall 2021 and the second inner sub-sidewall 2022. It can be learned from FIG. 3a that an area of an opening circumferentially encircled by the first inner sub-sidewall 2021 is greater than an area of an opening circumferentially encircled by the second inner sub-sidewall 2022.

In addition, when the power module 1 is fastened to the evaporator 2, the thermally conductive substrate 102 may be located in the opening circumferentially encircled by the first inner sub-sidewall 2021, and a part of the second surface 1022 is in overlapping contact with the connection wall 2023. Based on this, the outer side surface 1023 of the thermally conductive substrate 102 may be connected to the first inner sub-sidewall 2021 in a sealed manner. Alternatively, the part that is of the second surface 1022 of the thermally conductive substrate 102 and that is in overlapping contact with the connection wall 2023 may be connected to the connection wall 2023 in a sealed manner. Alternatively, both the outer side surface 1023 of the thermally conductive substrate 102 may be connected to the first inner sub-sidewall 2021 in a sealed manner, and the part that is of the second surface 1022 of the thermally conductive substrate 102 and that is in overlapping contact with the connection wall 2023 may be connected to the connection wall 2023 in the sealed manner. A connection mode thereof may be but is not limited to welding, bonding, or the like. Therefore, airtightness and stability of the connection between the power module 1 and the evaporator 2 can be improved.

In a possible embodiment of this application, the second surface 1022 may include at least one protruding portion 10221, and the at least one protruding portion 10221 may extend into the evaporation chamber 201 through the opening circumferentially encircled by the second inner sub-sidewall 2022. In this way, the at least one protruding portion 10221 is immersed in the refrigerant, so that an area of the thermally conductive substrate 102 immersed in the refrigerant is large. This helps improve the efficiency of heat exchange between the thermally conductive substrate 102 and the refrigerant.

In this application, to ensure sealing between the thermally conductive substrate 102 and the window 202, a sealing ring (not shown in FIG. 3a) may be further disposed between the thermally conductive substrate 102 and the window 202. A material of the sealing ring may be but is not limited to rubber. When the sealing ring is specifically disposed, the sealing ring may be disposed between the outer side surface 1023 of the thermally conductive substrate 102 and the inner sidewall 202 of the window 202, and the sealing ring may be sleeved on the thermally conductive substrate 102, so that when the thermally conductive substrate 102 is embedded into the window 202, the sealing ring is pressed by the inner sidewall 2022 of the window 202. In this way, the sealing ring fills a gap between the thermally conductive substrate 102 and the window 202, to implement sealing.

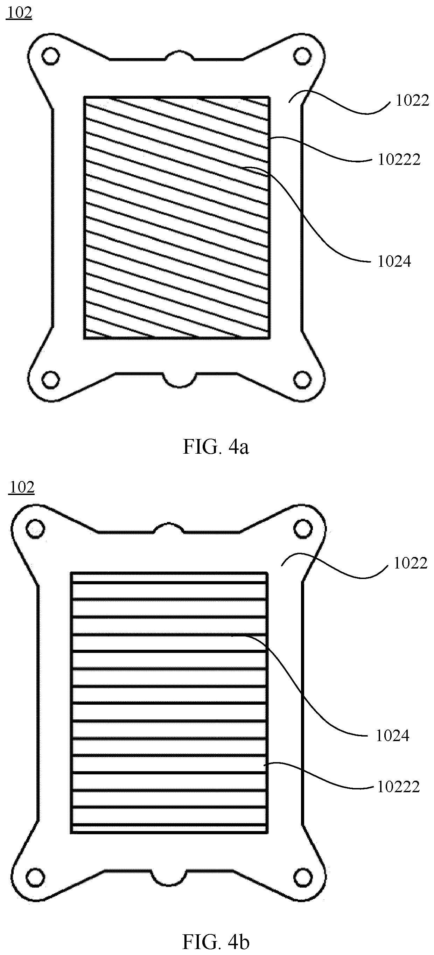

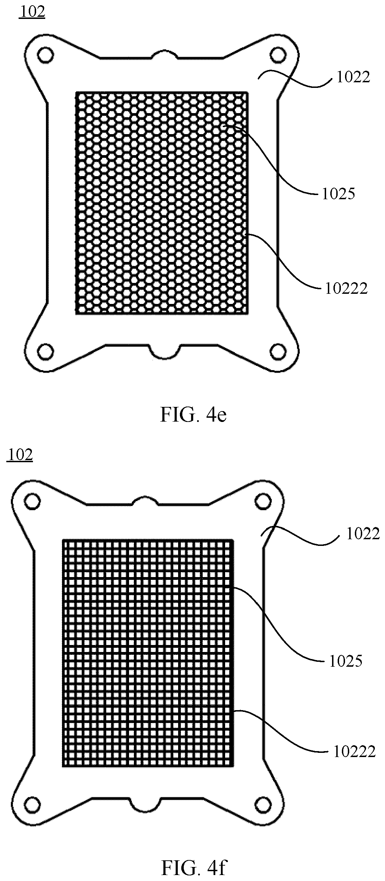

In addition, to improve efficiency of transferring heat from the power component 101 to the refrigerant, a heat dissipation enhancement structure may be further disposed on the thermally conductive substrate 102. For example, the heat dissipation enhancement structure may be disposed on the second surface 1022 of the thermally conductive substrate 102. When the heat dissipation enhancement structure is specifically disposed, refer to FIG. 4a. FIG. 4a is a diagram of a structure of the second surface 1022 of the thermally conductive substrate 102 according to an embodiment of this application. The heat dissipation enhancement structure may be a fin 1024 formed on the second surface 1022, and the fin 1024 may increase the area of the thermally conductive substrate 102 immersed in the refrigerant. In this application, the fin 1024 may be a protrusion structure formed on the second surface 1022, and the fin 1024 and the second surface 1022 may be of an integrally formed structure. Alternatively, the fin 1024 may be of an independently formed structure, and may be fastened to the second surface 1022 in a possible manner like welding. The fin 1024 may be disposed in a heat dissipation enhancement region 10222 of the second surface 1022. In addition, in a thickness direction of the thermally conductive substrate 102, at least a part of projection of the power component 101 on the second surface 1022 may be located in the heat dissipation enhancement region 10222. Because the second surface 1022 is in direct contact with the refrigerant in the evaporation chamber 201, the fin 1024 is disposed on the second surface 1022, so that the area of the thermally conductive substrate 102 immersed in the refrigerant can be effectively increased. This improves efficiency of heat exchange between the power component 101 and the refrigerant, and helps improve the heat dissipation performance of the power module 1.

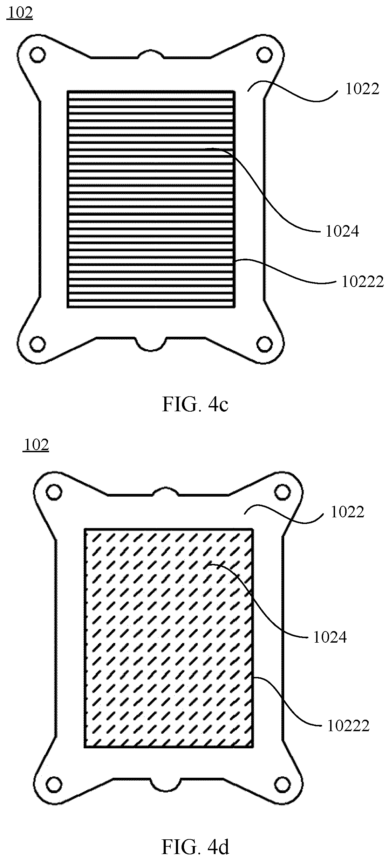

In this application, there may be a plurality of fins 1024 disposed in parallel. In the embodiment shown in FIG. 4a, the plurality of fins 1024 are disposed obliquely. In addition, the fins 1024 may be disposed in a possible form other than the manner shown in FIG. 4a. For example, FIG. 4b to FIG. 4d show several possible disposing forms of the fins 1024. For example, in FIG. 4b and FIG. 4c, there may be a plurality of fins 1024 disposed in parallel, and the plurality of fins 1024 are disposed in parallel with one side of the second surface 1022. For another example, in an embodiment shown in FIG. 4d, there are a plurality of rows of fins 1024 disposed in parallel, each row includes a plurality of fins 1024, and the plurality of rows of fins 1024 are disposed obliquely.

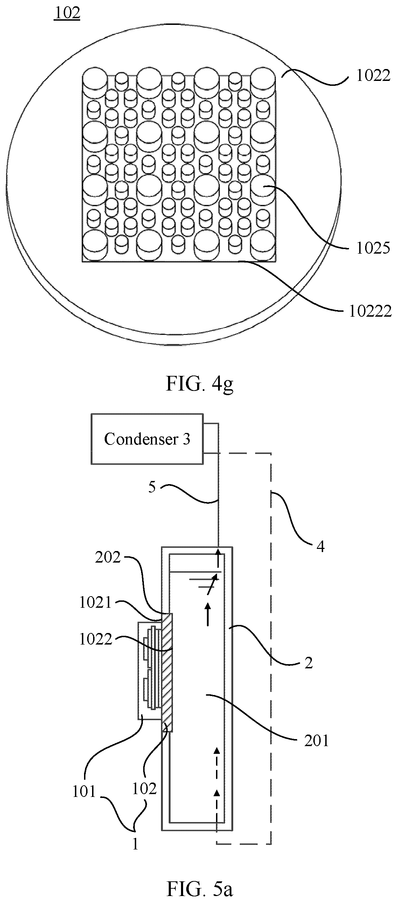

In addition, in this application, the heat dissipation enhancement structure may be disposed as a possible structure other than the fins 1024 shown in FIG. 4a to FIG. 4d. For example, refer to FIG. 4e to FIG. 4g. FIG. 4e to FIG. 4g are diagrams of structures of other several second surfaces 1022 according to an embodiment of this application. FIG. 4g is a diagram of a three-dimensional structure of the second surface 1022. In FIG. 4e to FIG. 4g, the heat dissipation enhancement structure may be a capillary structure 1025. The capillary structure 1025 may be but is not limited to a metal mesh structure, a metal powder sintering structure, or the like, and adsorbs liquid. The capillary structure 1025 may alternatively be disposed in the heat dissipation enhancement region 10222 of the second surface 1022, so that the area of the thermally conductive substrate 102 immersed in the refrigerant can be effectively increased.

It should be noted that a shape of the thermally conductive substrate 102 is not specifically limited in this application, and may be a rectangle-like shape shown in FIG. 4a to FIG. 4f, or may be a circle shown in FIG. 4g, or may be another possible regular shape or irregular shape. In some other possible embodiments of this application, the heat dissipation enhancement structure may alternatively be a groove or a protrusion located on the second surface 1022, provided that the area of the thermally conductive substrate 102 immersed in the refrigerant can be increased.

When the evaporator 2 is connected to the condenser 3, refer to FIG. 5a. FIG. 5a is a diagram of a connection relationship of a heat dissipation system according to an embodiment of this application. The evaporation chamber 201 of the evaporator 2 may communicate with the condenser 3. During specific implementation, the evaporation chamber 201 may be connected to the condenser 3 through a pipeline, but this is not limited. The pipeline may be a hose, so that the evaporator 2 is more conveniently connected to the condenser 3. In some possible application scenarios, for example, when space for disposing the heat dissipation system is large, the evaporator 2 may alternatively be connected to the condenser 3 through a rigid pipeline.

According to the heat dissipation system provided in this application, when the power module 1 works, the heat may be conducted from the power component 101 to the thermally conductive substrate 102. Because at least a part of surfaces of the thermally conductive substrate 102 is in direct contact with the refrigerant in the evaporation chamber 201 of the evaporator 2, the liquid refrigerant may be heated and vaporized to form the vapor. After the vapor enters the condenser 3 and is condensed into the liquid state, the liquid refrigerant may flow back to the evaporation chamber 201. In FIG. 5a, a solid line with an arrow indicates a flowing direction of the gaseous refrigerant, and a dashed line with an arrow indicates a flowing direction of the liquid refrigerant. It can be understood that, in the foregoing refrigerant phase-change process, a large amount of heat generated by the power component 101 may be taken away, to perform heat dissipation for the power component 101. In addition, phase-change heat exchange of the refrigerant can be used to effectively reduce thermal resistance from the power module 1 to air, thereby effectively improving a heat dissipation capability of the power module 1.

Because cycling of the refrigerant between the evaporator 2 and the condenser 3 needs to undergo a liquid-to-gas state transition and a gas-to-liquid state transition, to distinguish a gas flowing path from a liquid flowing path, the evaporator 2 may be connected to the condenser 3 through at least one liquid flowing pipeline 4 and at least one gas flowing pipeline 5. For example, in FIG. 5a, a dashed line represents the liquid flowing pipeline 4 configured to connect the evaporator 2 and the condenser 3, and a solid line represents the gas flowing pipeline 5 configured to connect the evaporator 2 and the condenser 3. In this way, the vapor formed by the refrigerant may enter the condenser 3 through the at least one gas flowing pipeline 5, and the liquid refrigerant condensed through the condenser 3 flows back to the evaporation chamber 201 through the at least one liquid flowing pipeline 4. In this way, the refrigerant efficiently cycle between the evaporator 2 and the condenser 3. In some possible embodiments of this application, the evaporator 2 may alternatively be connected to the condenser 3 through one pipe, to simplify a structure of the heat dissipation system.

In this application, the refrigerant condensed into the liquid state by the condenser 3 can flow back to the evaporation chamber 201 under an action of gravity. Based on this, when the condenser 3 and the evaporator 2 are arranged, the condenser 3 and the evaporator 2 may be arranged in a gravity direction. For example, in the gravity direction, the condenser 3 may be located above the evaporator 2. The condenser 3 and the evaporator 2 may be arranged along a straight line in the gravity direction, or may be staggered in the gravity direction. In this way, without being driven by a pump or another power device, the refrigerant in the evaporation chamber 201 can enter the condenser 3 after being vaporized, and the refrigerant condensed through the condenser 3 into the liquid refrigerant can flow back to the evaporation chamber 201 under the action of gravity, thereby implementing efficient cycling of the refrigerant between the evaporator 2 and the condenser 3.

When the heat dissipation system is placed in the gravity direction, the gravity direction may be defined as a direction from the top to the bottom when a device in which the heat dissipation system is used is in a normal use state and is placed in a customary manner in the art. For example, when the heat dissipation system is used in a photovoltaic inverter, and the photovoltaic inverter is in the normal use state, the gravity direction may be understood as a direction from the top to the bottom of the photovoltaic inverter. In this case, the heat dissipation system is placed in the direction from the top to the bottom of the photovoltaic inverter.

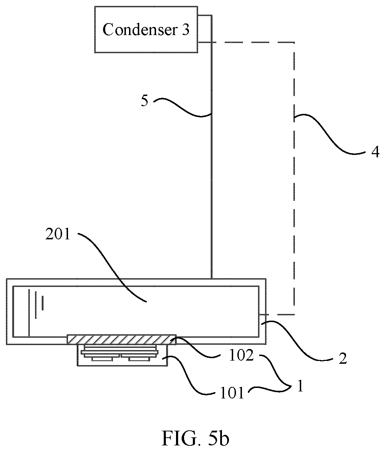

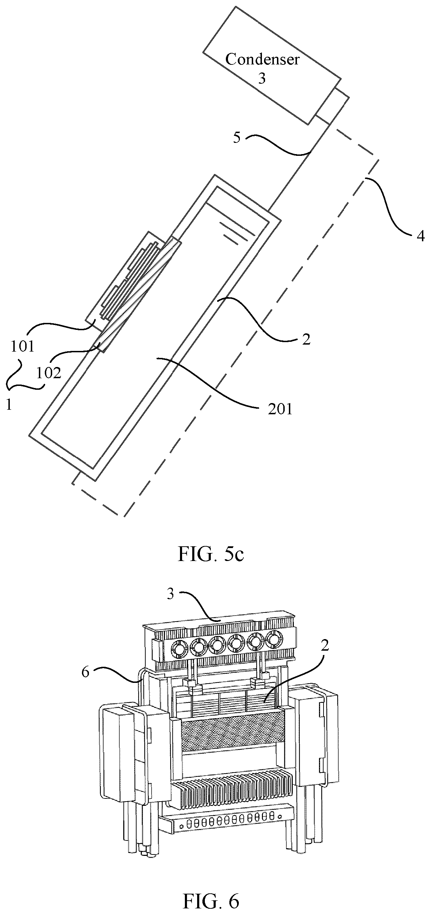

In addition, the evaporator 2 and the condenser 3 each may be disposed in any direction, and may be adjusted based on a specific application scenario. This is not specifically limited in this application, provided that the liquid refrigerant condensed through the condenser 3 can flow back to the evaporation chamber 201. For example, in the embodiment shown in FIG. 5a, the condenser 3 and the evaporator 2 are arranged along the straight line in the gravity direction, and the condenser 3 and the evaporator 2 are disposed in parallel. For another example, in the embodiment shown in FIG. 5b, the condenser 3 and the evaporator 2 are arranged along the straight line in the gravity direction, and the condenser 3 and the evaporator 2 are perpendicular to each other. For still another example, in the embodiment shown in FIG. 5c, the condenser 3 and the evaporator 2 are staggered in the gravity direction, and both the condenser 3 and the evaporator 2 are disposed obliquely.

In addition, there is a first included angle between the first surface 1021 of the thermally conductive substrate 102 of the power module 1 and the gravity direction, and the first included angle may be greater than or equal to 0° and less than or equal to 180°. For example, in the embodiment shown in FIG. 5a, the thermally conductive substrate 102 of the power module 1 may be embedded into the evaporator 2 via a sidewall that is of the evaporator 2 and that is parallel to the gravity direction. In this case, the first included angle may be 0°, which may be understood that the first surface 1021 is parallel to the gravity direction. In this case, the thickness direction of the thermally conductive substrate 102 may be perpendicular to the first surface 1021. For another example, in the embodiment shown in FIG. 5b, the thermally conductive substrate 102 of the power module 1 is embedded into the evaporator 2 via a sidewall that is of the evaporator 2 and that faces away from the condenser 3. In this case, the first included angle may be 90°. For still another example, in the embodiment shown in FIG. 5c, the thermally conductive substrate 102 of the power module 1 is embedded into the evaporator 2 via a sidewall that is of the evaporator 2 and that is obliquely disposed. In this case, the first included angle may be 45°.

The heat dissipation system provided in this application may be used in various possible power devices. A specific type of the power device is not limited in this application. For example, the power device may be a photovoltaic power generation device like a photovoltaic inverter. FIG. 6 is a diagram of a structure of a possible power device according to an embodiment of this application. In addition to the heat dissipation system, the power device may further include a chassis 6. The evaporator 2 may be located inside the chassis 6 or outside the chassis 6, and the condenser 3 is located outside the chassis 6. The power device has a strong heat dissipation capability, so that product performance of the power device can be improved, thereby improving product competitiveness of the power device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation system, comprising a power module, an evaporator, and a condenser, wherein
the power module comprises a thermally conductive substrate and a power component, the thermally conductive substrate has a first surface, and the power component is fastened to the first surface;
the evaporator has an evaporation chamber, the evaporation chamber is filled with a refrigerant, at least one sidewall of the evaporator is provided with a window, the thermally conductive substrate is embedded into the window, at least a part of surfaces of the thermally conductive substrate is immersed in the refrigerant, and the first surface is located on an outer side of the evaporation chamber; and
the condenser communicates with the evaporation chamber, heat generated by the power component is transferred to the evaporation chamber through the thermally conductive substrate, the refrigerant in the evaporation chamber enters the condenser after the refrigerant is heated and vaporized, and the refrigerant is condensed into a liquid state by the condenser, and flows back to the evaporation chamber.

2. The heat dissipation system according to claim 1, wherein the refrigerant is condensed into the liquid state by the condenser, and flows back to the evaporation chamber under an action of gravity.

3. The heat dissipation system according to claim 1 or 2, wherein when the heat dissipation system is placed in a gravity direction, the condenser is located above the evaporator.

4. The heat dissipation system according to any one of claims 1 to 3, wherein the evaporator is connected to the condenser through at least one liquid flowing pipeline and at least one gas flowing pipeline.

5. The heat dissipation system according to any one of claims 1 to 4, wherein the thermally conductive substrate has a second surface, the second surface and the first surface are disposed away from each other, and at least a part of the second surface is immersed in the refrigerant.

6. The heat dissipation system according to claim 5, wherein the at least a part of surfaces comprises the second surface and at least a part of an outer side surface of the thermally conductive substrate.

7. The heat dissipation system according to claim 5 or 6, wherein a heat dissipation enhancement structure is disposed on the second surface, and the heat dissipation enhancement structure is located in a heat dissipation enhancement region of the second surface, and is configured to increase an area of the thermally conductive substrate immersed in the refrigerant; and in a thickness direction of the thermally conductive substrate, at least a part of projection of the power component on the second surface is located in the heat dissipation enhancement region.

8. The heat dissipation system according to claim 7, wherein the heat dissipation enhancement structure is a groove or a protrusion located on the second surface, or the heat dissipation enhancement structure is a fin or a capillary structure disposed on the second surface.

9. The heat dissipation system according to any one of claims 5 to 8, wherein the outer side surface of the thermally conductive substrate is connected to an inner sidewall of the window in a sealed manner.

10. The heat dissipation system according to any one of claims 5 to 9, wherein the inner sidewall of the window is in a step shape, the inner sidewall comprises a first inner sub-sidewall, a second inner sub-sidewall, and a connection wall connecting the first inner sub-sidewall and the second inner sub-sidewall, an area of an opening circumferentially encircled by the first inner sub-sidewall is greater than an area of an opening circumferentially encircled by the second inner sub-sidewall, the thermally conductive substrate is located in the opening circumferentially encircled by the first inner sub-sidewall, and a part of the second surface is in overlapping contact with the connection wall.

11. The heat dissipation system according to claim 10, wherein the second surface further comprises at least one protruding portion, and the protruding portion extends into the evaporation chamber through the opening circumferentially encircled by the second inner sub-sidewall.

12. The heat dissipation system according to claim 10 or 11, wherein the outer side surface of the thermally conductive substrate is connected to the first inner sub-sidewall in the sealed manner; or
the part of the second surface that is of the thermally conductive substrate and that is in overlapping contact with the connection wall is connected to the connection wall in the sealed manner.

13. The heat dissipation system according to claim 12, wherein a sealing ring is disposed between the outer side surface of the thermally conductive substrate and the inner sidewall of the window, the sealing ring is sleeved on the thermally conductive substrate, and the inner sidewall presses the sealing ring.

14. The heat dissipation system according to any one of claims 1 to 13, wherein there is a first included angle between the first surface and the gravity direction, and the first included angle is greater than or equal to 0° and less than or equal to 180°.

15. A power device, comprising a chassis and the heat dissipation system according to any one of claims 1 to 14, wherein the evaporator is located inside the chassis or outside the chassis, and the condenser is located outside the chassis.
